# EUROPEAN PATENT SPECIFICATION

(11) **EP 4 718 087 B1**
(45) Date of publication and mention of the grant of the patent: **25.11.2026**
(21) Application number: 24203600.2
(22) Date of filing: 30.09.2024
(51) Int. Cl.: G01R 31/08, G01R 31/58, H02H 3/05, H02H 3/28, G01R 19/25

(54) **A FAULT DETECTION METHOD FOR A POWER TRANSMISSION LINE IN AN AC POWER TRANSMISSION SYSTEM**
FEHLERERKENNUNGSVERFAHREN FÜR EINE STROMÜBERTRAGUNGSLEITUNG IN EINER WECHSELSTROMVERSORGUNG
PROCÉDÉ DE DÉTECTION DE DÉFAUT POUR UNE LIGNE DE TRANSMISSION D'ÉNERGIE DANS UNE ALIMENTATION EN COURANT ALTERNATIF

(43) Date of publication of application: 01.04.2026
(73) Proprietor: Hitachi Energy Ltd, 8050 Zürich (CH)
(72) Inventor: Gajic, Zoran, 723 47 Västerås (SE)
(74) Representative: AWA Sweden AB

(56) References cited:
- EP-A1- 4 270 702
- US-A1- 2017 059 636

## Description

### Technical field

The present disclosure relates to a fault detection method for a power transmission line in an alternating current, AC, power transmission system and a fault detection system for an AC power transmission system.

### Background

In an AC power transmission system, such as a high voltage (HV) or a medium voltage (MV) power transmission system, there is a risk for major short-circuit faults, e.g. from a phase to ground or between phases. Such faults have to be detected and remedied as soon as possible. Therefore, the power transmission lines are monitored. Prior art solutions typically utilize measurements of current or impedance. They have shortcomings. In particular for long power transmission lines they give uncertain decisions due to inaccurate calculations. The detection of some types of faults requires a combination of local and remote measurements of voltages and currents at two ends of a monitored part, also called protection zone, of the power transmission line. Typically, a local IED (Intelligent Electrical Device) and a remote IED are used, where information about the measurements is sent from the remote IED to the local IED via a communication link. Commonly, the communication link is wired, typically a fiber optic cable network, although wireless communication exists as well. However, occasionally the communication links are exposed to channel asymmetry, i.e. a difference in the transmit-receive channel delays, causing false indications of faults on the power transmission line. The channel asymmetry is caused by problems in the optic cable network, often having several multiplexers etc., extending over long distances. The channel asymmetry adds to the uncertainty of the fault decisions. EP4270702 A1 relates to detecting a fault in a protected line constituting at least a portion of a transmission line in a power transmission system.

### Summary

In view of the above, it is an object of the present disclosure to provide an improved fault detection method for the power transmission line.

To achieve this object, as well as other objects which will be evident from the following description, a method as defined in independent claim 1 is provided according to the present disclosure. Preferred variants of the method will be evident from the dependent claims.

More specifically, there is provided, according to a first aspect of the present disclosure, fault detection method for a power transmission line in an alternating current, AC, power transmission system. The method comprises:
- measuring, at a local position of the power transmission line, phase voltages and phase currents, and determining the phasors thereof as measured local voltage phasors and measured local current phasors;
- obtaining transmission properties for the power transmission line from the local position to a remote position at a distance from the local position and for associated devices, wherein the transmission properties comprise series parameters, shunt parameters, and the distance from the local position to the remote position;
- estimating, for the remote position, estimated remote voltage phasors and estimated remote current phasors on basis of the measured local voltage phasors, the measured local current phasors, and the transmission properties;
- receiving, at the local position, via a communication link, data relating to remote phase currents, which have been measured at the remote position, and determining the phasors thereof as measured remote current phasors;
- determining whether a fault has occurred or not on basis of at least one of a combination of the estimated remote current phasors and the measured remote current phasors and a combination of the estimated remote voltage phasors and the measured remote voltage phasors; and
- when it is determined that a fault has occurred, determining whether the fault is a true fault or a false fault, comprising:
   ∘ determining a measured remote positive sequence current phasor from the measured remote current phasors;
   ∘ determining an estimated remote positive sequence current phasor from the estimated remote current phasors;
   ∘ comparing a first phase angle and a first magnitude of the estimated remote positive sequence current phasor with a second phase angle and a second magnitude of the measured remote positive sequence current phasor;
   ∘ determining, on basis of the comparison, whether there is a significant channel asymmetry on the communication link; and
   ∘ determining that the fault is false fault if there is a significant channel asymmetry.

It should be noted that the term shunt parameters is understood as a common term for both impedance and admittance.

The series parameters may comprise a line impedance for the power transmission line. The line impedance primarily comprises inductive reactance, but resistance may be included as well.

The shunt parameters may comprise at least one of a shunt factor directly between the power transmission line and ground, and a shunt factor of at least one shunt reactor comprised in the associated devices and connected with the power transmission line. Shunt reactors, which can be fixed or variable, are commonly used on long power transmission lines and are connected between the power transmission line and ground. The power transmission line as such interacts capacitively with the ground, i.e. as if it comprises capacitors connected between the power transmission line and ground. Depending on how their properties impact the estimation one or both of the line generated shunt factor and the reactor generated shunt factor may, thus, be included.

The operation of estimating may comprise determining a first matrix having matrix parameters determined on basis of the distance, the line impedance and the shunt factor, and multiplying the first matrix with a second matrix having matrix parameters based on the measured local voltage phasors and the measured local current phasors.

The associated devices may comprise at least one series capacitor, wherein the series parameters comprise a series capacitance of the at least one series capacitor, and wherein the matrix parameters of the first matrix are additionally based on the series capacitance.

The operation of determining whether a fault has occurred or not may comprise determining an estimated remote positive sequence current phasor of the estimated remote current phasors.

The method may further comprise preventing, when it has been determined that the fault is a false fault, triggering of a breaker of the power transmission line.

The operation of determining whether there is a significant channel asymmetry on the communication link may comprise determining that there is a significant channel asymmetry if a phase angle difference between the first and second phase angles deviates more than a predetermined extent from 180 degrees while a magnitude difference between the first and second magnitudes deviates less than a predetermined extent from zero.

The method may comprise determining an amount of channel asymmetry on basis of deviation of the phase angle difference, and logging data regarding that amount.

The operation of comparing may comprise determining a phasor sum of the estimated remote positive sequence current phasor and the measured remote positive sequence current phasor, and determining a magnitude difference between the first and second magnitudes, and said determining whether there is a significant channel asymmetry comprising determining that there is a significant channel asymmetry if the phasor sum exceeds a first threshold while the magnitude difference is below a second threshold.

Further, the method may comprise logging data regarding results of the determinations of the phasor sum and the magnitude difference and adapting the first and second thresholds on basis of the logged data.

According to another aspect of the present disclosure there is provided a fault detection system for an alternating current, AC, power transmission system comprising a power transmission line, wherein the fault detection system comprises at least one intelligent electric device, IED, connectable with the power transmission line, wherein a local IED of the at least one IED is configured to:
- measure, at a local position of the power transmission line, phase voltages and phase currents, and determine the phasors thereof as measured local voltage phasors and measured local current phasors;
- obtain transmission properties for the power transmission line from the local position to a remote position at a distance from the local position and for associated devices, wherein the transmission properties comprise series parameters, shunt parameters, and the distance from the local position to the remote position;
- estimate, for the remote position, estimated remote voltage phasors and estimated remote current phasors on basis of the measured local voltage phasors, the measured local current phasors, and the transmission properties;
- receive, at the local position, via a communication link, data relating to remote phase currents, which have been measured at the remote position, and determine the phasors thereof as measured remote current phasors;
- determine whether a fault has occurred or not on basis of at least one of a combination of the estimated remote current phasors and the measured remote current phasors and a combination of the estimated remote voltage phasors and the measured remote voltage phasors;
- determine, when it is determined that a fault has occurred, whether the fault is a true fault or a false fault, comprising:
   ∘ determining a measured remote positive sequence current phasor from the measured remote current phasors;
   ∘ determining an estimated remote positive sequence current phasor from the estimated remote current phasors;
   ∘ comparing a first phase angle and a first magnitude of the estimated remote positive sequence current phasor with a second phase angle and a second magnitude of the measured remote positive sequence current phasor;
   ∘ determining, on basis of the comparison, whether there is a significant channel asymmetry on the communication link; and
   ∘ determine that the fault is a false fault if there is a significant channel asymmetry.

The at least one IED may comprise a remote IED positioned at the remote position, wherein the remote IED is configured to measure the remote phase currents.

According to a further aspect of the present disclosure there is provided a computer program product comprising instructions which, when downloaded into an intelligent electronic device, IED, connectable to a power transmission line of a power transmission system, cause the intelligent electronic device to carry out the operations of the above method.

### Brief description of the drawings

The present disclosure will by way of example be described in more detail with reference to the appended drawings, which show example embodiments of the disclosure.
Fig. 1 schematically illustrates some basic parts of a power transmission system.
Fig. 2 is a schematic flow chart of the method according to the present disclosure.
Figs. 3 and 4 schematically illustrates power transmission line models.
Fig. 5 is an operate-restraint diagram of currents.
Fig. 6 is a diagram of a voltage along the transmission line.
Fig. 7 is a diagram of a current along the transmission line.
Fig. 8 and 9 illustrate relations between different currents.
Fig. 10 illustrates a computer program product.

### Detailed description

The present disclosure will now be described more fully hereinafter with reference to the accompanying drawings, in which currently preferred embodiments of the disclosure are shown. This disclosure may, however, be embodied in many different forms and should not be construed as limited to the embodiments set forth herein; rather, these embodiments are provided for thoroughness and completeness, and fully convey the scope of the disclosure to the skilled person.

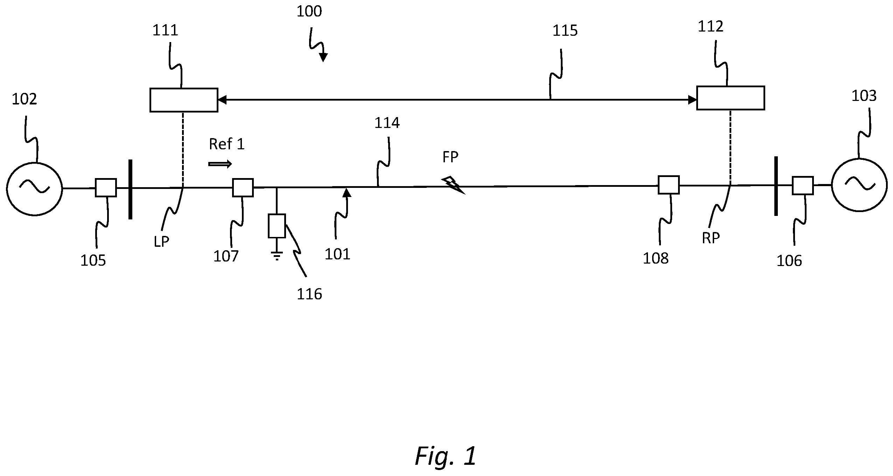

Fig. 1 shows a most general example of a power transmission system 100 comprising a power transmission line 101, having one or more phases, for example three phases, and at least two ends. In the illustrated example there are two ends. An electrical apparatus 102, 103 is connected to the transmission line 101 at each end thereof. The electrical apparatus 102, 103 may be an electrical source or an electrical load. The power transmission line 101 is provided with one or more switching devices 105, 106, 107, 108, or breakers, allowing restriction of the flow of current in the power transmission system 100. The switching devices 105-108 are typically closed during normal operatin of the transmission system 100. A fault detection system for the power transmission system 100 comprises one or more Intelligent Electrical Devices, IEDs, 111, 112. Each IED 111, 112 is connected to the power transmission line 101, typically at an end thereof, either directly or via some other device, and is arranged to monitor the electrical activity in the power transmission line 101, for instance by means of measuring currents and voltages in the power transmission line 101 and using the measurements to detect abnormalities. For the purposes of this disclosure, one of the IEDs 111, 112 is defined as a local IED 111, and the position of the transmission line 101 where the local IED 111 is connected is called a local position. The other IED 112 is defined as a remote IED 112, connected to the power transmission line 101 at a remote position. Furthermore, at least the local IED 111 is arranged to detect a fault in the power transmission line 101 and is arranged to switch one or more of the switching devices 105-108 to an open state, also referred to as tripping the breaker, when necessary. It should be noted that the power transmission line 101, or a portion thereof, which is monitored by the local IED 111, constitutes a protection zone 114. The protection zone 114 may correspond with the distance between the local and remote IEDs 111, 112, but it may be both shorter and longer than that distance as well.

As understood by the person skilled in the art the overall structure of the power transmission system 100 shown in Fig. 1 is a mere example among an almost infinite number of different variants. To give just a brief view of the variety, and in addition to what has been described above, the power transmission system may be a part of or connected to the grid, the power sources may be different kinds of power sources such as wind power plants, solar power plants, nuclear power plants, a transformer, etc., the loads may be different kinds of loads such as a production site, etc. The power transmission system 100 may comprise a plurality of power transmission lines 101, etc. The power transmission line 101 may be an HV AC line or an MV AC line, it may extend between power sources, between a power source and a load, etc., and, thus, as recognized above, it may constitute what is also referred to as a distribution line. Further, the power transmission line 101 may comprise, for instance, a power cable, an overhead line or combinations thereof. The length of the power transmission line 101 may vary to a large extent, from a few kilometres, or even shorter, up to hundreds of kilometres.

Furthermore, the power transmission system 100 comprises a communication link 115, which is typically wired. The communication link 115 is used for sending data between the local and remote IEDs 111, 112, such as sending measurement data from the remote IED 112 to the local IED 111. The communication link 115 is supervised in order to detect channel asymmetry which may cause false indications of faults on the power transmission line 101.

Further, the power transmission system 1 may comprise one ore more shunt reactors 116 connected with the power transmission line 101.

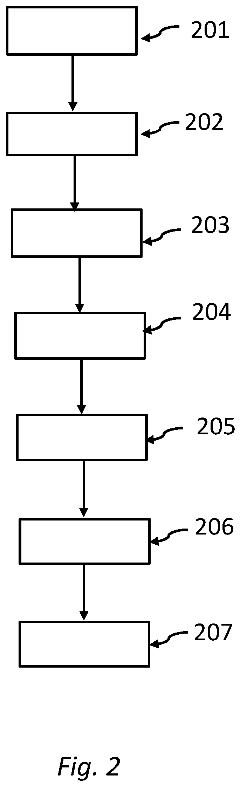

According to an exemplifying embodiment of the present method of detecting a fault in the AC power transmission system 100, as illustrated in the flow chart of Fig. 2, the method comprises the operations of:
- measuring 201, at a local position of the power transmission line 101, such as at the local IED 111, phase voltages and phase currents, and determining the phasors thereof as measured local voltage phasors and measured local current phasors;
- obtaining 202 transmission properties for the power transmission line 101 from the local position LP to a remote position RP at a distance from the local position LP and for associated devices, wherein the transmission properties comprise series parameters, shunt parameters, and the distance from the local position LP to the remote position RP;
- estimating 203, for the remote position RP, estimated remote voltage phasors and estimated remote current phasors on basis of the measured local voltage phasors, the measured local current phasors, and the transmission properties;
- receiving 204, at the local position LP, via the communication link 115, data relating to remote phase currents, which have been measured at the remote position RP, such as by means of the remote IED 112, and determining the phasors thereof as measured remote current phasors;
- determining 205 whether a fault has occurred or not on basis of at least one of a combination of the estimated remote current phasors and the measured remote current phasors and a combination of the estimated remote voltage phasors and the measured remote voltage phasors; and
- when it is determined that a fault has occurred, determining 206 whether the fault is a true fault or a false fault, comprising:
   ∘ determining a measured remote positive sequence current phasor from the measured remote current phasors;
   ∘ determining an estimated remote positive sequence current phasor from the estimated remote current phasors;
   ∘ comparing a first phase angle and a first magnitude of the estimated remote positive sequence current with a second phase angle and a second magnitude of the measured remote positive sequence current phasor,
   ∘ determining, on basis of the comparison, whether there is a significant channel asymmetry on the communication link, and
   ∘ determining 207 that the fault is a false fault if there is a significant channel asymmetry.

The local IED 111 is configured to perform the above-mentioned operations of the method. More particularly, for instance, the operation of measuring, at a local position of the power transmission line, phase voltages and phase currents, and determining the phasors thereof as measured local voltage phasors and measured local current phasors may involve actions performed fully by the local IED 111. Thus, the local IED 111 may perform the measurements of phase currents and phase voltages at the local position LP and calculate the associated phasors. Further, the data relating to remote phase currents may have been generated by the remote IED 112 by measuring the phase currents at the remote position RP and transforming them appropriately to be sent via the communication link 115.

The operation of determining 206 whether a detected fault is a true fault or a false fault may be regarded as a supervision of the communication link 115. If a fault has been detected, i.e. when it has been determined that a fault has occurred, the fault may be a true fault which has actually occurred somewhere on the power transmission line 101. However, occasionally the communication link 115 is subjected to channel asymmetry, that is a delay in the signal transmission on the communication link 115, which causes a difference in the estimated and measured remote values that is interpreted as an indication of a fault. However, this fault indication is false. Thus, by means of the supervision of the communication link 115 an unnecessary tripping of one or more breakers 105-108 can be prevented.

As will be further described below, the associated devices may be, for example, series capacitors connected in series with the power transmission line 101, and shunt reactors 116 connected between the power transmission line 101 and ground. It should be mentioned that as understood by the person skilled in the art the "power transmission line" may include both the wires as such, the switching devices/breakers 105-108 and other components integrated with the wires.

According to embodiments of the method, the series parameters additionally comprise a line impedance for the power transmission line 101. The line impedance is predetermined and may be obtained from data sources containing properties of the power transmission line 101.

The estimation may employ a matrix notation in order to facilitate the actual calculations that are made, by comprising determining a first matrix having matrix parameters determined on basis of the length of the power transmission line, the line impedance and the shunt factor, and multiplying the first matrix with a second matrix having matrix parameters based on the measured local voltage phasors and the measured local current phasors.

Thus, the estimation includes determining phasors for all of the local phase voltages and local phase currents, for instance by sampling the measured local phase voltages and local phase currents, and applying a discrete Fourier transform, DFT, filter, or some other kind of appropriate filtering. Then, according to the matrix calculation, sequence phasors for the measured local current phasors and the measured local voltage phasors of a three-phase power transmission line are determined according to: $\begin{matrix}\left(\begin{matrix}{I}_{0} \\ {I}_{1} \\ {I}_{2}\end{matrix}\right) = \frac{1}{3} ∗ \left(\begin{matrix}1 & 1 & 1 \\ 1 & a & {a}^{2} \\ 1 & {a}^{2} & a\end{matrix}\right) ∗ \left(\begin{matrix}{I}_{A} \\ {I}_{B} \\ {I}_{C}\end{matrix}\right) \\ \left(\begin{matrix}{U}_{0} \\ {U}_{1} \\ {U}_{2}\end{matrix}\right) = \frac{1}{3} ∗ \left(\begin{matrix}1 & 1 & 1 \\ 1 & a & {a}^{2} \\ 1 & {a}^{2} & a\end{matrix}\right) ∗ \left(\begin{matrix}{U}_{A} \\ {U}_{B} \\ {U}_{C}\end{matrix}\right)\end{matrix}$ Eqn. 1 and 2 where the three phases are indexed by A, B, and C, and the positive, negative and zero sequences are indexed by 1, 2, and 0, respectively. The factor a is a complex operator, such that *a*=*e ^{j*120°},* and *j²* = -*1*. Consequently, *I₀, I₁, I₂* represent the sequence current phasors for the zero, positive, and negtive sequences, and *U₀, U₁, U₂,* represent the sequence voltage phasors for the zero, positive, and negative sequences.

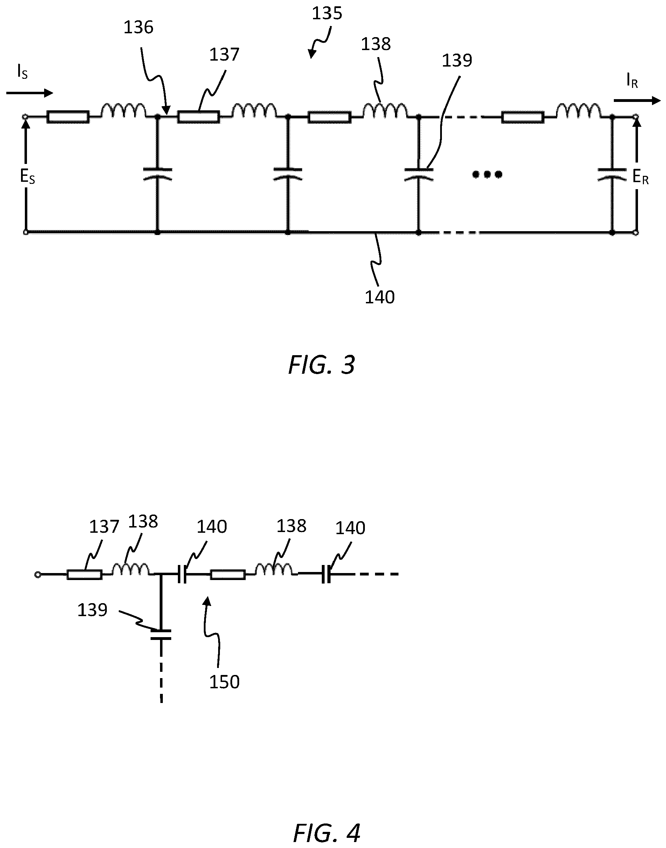

Referring to Fig. 3, for a general power transmission line there is a power transmission line model 135, which has a line impedance represented by series connected resistors 137 and inductors 138 along, and inherent of, the power transmission line 136, and shunt capacitors 139 between the power transmission line 136 and a parallel line 140, which for instance can be ground. A two-port network model can be applied on the power transmission line model 135. The two-port network is a model of any electric network or device which has two pairs of terminals which can be connected to external equipment, and is represented by a black box having a first port with two terminals on one side of the black box, and another port with two terminals on the opposite side of the black box. For the power transmission line model, the two-port equation on matrix notation becomes: $\left[\begin{matrix}{E}_{S} \\ {I}_{S}\end{matrix}\right] = \left[\begin{matrix}A & B \\ C & D\end{matrix}\right] ∗ \left[\begin{matrix}{E}_{R} \\ {I}_{R}\end{matrix}\right]$ Eqn. 3

*E_{S}* and *I_{S}* are a sending line end, i.e. the local position, voltage and current phasor pair for either positive, negative, or zero sequence. *E_{R}* and *I_{R}* are receiving line end, i.e. the remote position, voltage and current phasor pair for the same sequence. Referring to the present disclosure, the sending line end voltage and current phasor pair *E_{S}* and *I_{S}* corresponds with the sequence voltage phasors *U₀, U₁, U₂* and the sequence current phasors *I₀, I₁, I₂* of the local phase voltages and the local phase currents measured at the local IED 111. Similarly, the receiving line end voltage and current phasor pair *E_{R}* and *I_{R}* corresponds with the estimated sequence voltage and current phasors at the remote position *U₀@RP, U₁@RP, U₂@RP, I₀@RP, I₁@RP, I₂@RP.* A, B, C, and D are complex parameters, and they are fixed complex numbers for a particular power transmission line 101 and a selected remote position. By simple mathematical manipulations the matrix equation can be rearranged to adapt to the present purposes, that is the estimation, as follows: $\left[\begin{matrix}{E}_{R} \\ {I}_{R}\end{matrix}\right] = \left[\begin{matrix}D & - B \\ - C & A\end{matrix}\right] ∗ \left[\begin{matrix}{E}_{S} \\ {I}_{S}\end{matrix}\right]$ Eqn. 4 Thereby, the ABCD matrix corresponds with the above-mentioned first matrix, and the matrix with parameters *E_{S}* and *I_{S}* corresponds with the above-mentioned second matrix, while the matrix with parameters *E_{R}* and *I_{R}* contains the estimated sequence voltage and sequence current for the sequence being processed. However, this is merely true if the impact of shunt reactors is not taken into account. On the other hand, when shunt reactors and series capacitors are present in the AC power transmission system 100, it is advantageous to include them when estimating the voltages and currents for the remote position RP. This will be further described below.

The following formulas can be used to calculate the matrix ABCD parameters for the power transmission line 101 itself: $A = cosh \left(d∗\sqrt{z ′ ∗ y ′}\right)$ Eqn. 5 $B = \sqrt{\frac{z ′}{y ′}} ∗ sinh \left(d∗\sqrt{z ′ ∗ y ′}\right)$ Eqn. 6 $C = \sqrt{\frac{y ′}{z ′}} ∗ sinh \left(d∗\sqrt{z ′ ∗ y ′}\right)$ Eqn. 7 $D = A$ Eqn. 8
where z' is a series impedance per unit length of the power transmission line, i.e. Z/LineLength in Ω/km where Z is the line impedance in Ohms;
y' is admittance to ground per unit length of the power transmission line, i.e. Y/LineLength in Siemens/km, where Y is the total shunt admittance in Siemens;
LineLength is the length of the power transmission line being protected in km; and d is the distance from the local position LP to the remote position RP.

It should be noted that these ABCD parameters have fixed complex values for a specified remote position and that they can be calculated off-line and predetermined. Two sets of such matrix parameters may be used for a power transmission line. One ABCD-parameter set represents the transmission line network model for positive and negative sequence, and the other ABCD-parameter set represents the transmission line network model for zero sequence. Once these ABCD parameters have been obtained corresponding 2x2 matrixes for the power transmission line 101 can be established. In a real situation, typically all the required data is available in form of predetermined tables of relevant values. Further, it is to be noted that when two or more two-port networks are interconnected, i.e. connected in series such that an output port of one two-port network is connected with an input port of another two-port network, their ABCD matrices are multiplied with each other.

Shunt reactors 116 are commonly used on, and connected directly to, long Overhead Lines, OHLs, and cables in order to compensate for the reactive power generated by the shunt capacitances, represented by the shunt capacitors 139 in the model 135, of the transmission line 101.

The sequence impedances of such a shunt reactor are zero sequence reactance X₀, positive sequence reactance X₁, and negative sequence reactance X₂. Applying the two-port network model to the shunt reactor renders two ABCD matrices as follows: $\left[\begin{matrix}{A}_{1} & {B}_{1} \\ {C}_{1} & {D}_{1}\end{matrix}\right] = \left[\begin{matrix}1 & 0 \\ \frac{1}{jX 1} & 1\end{matrix}\right]$ Eqn. 9 $\left[\begin{matrix}{A}_{0} & {B}_{0} \\ {C}_{0} & {D}_{0}\end{matrix}\right] = \left[\begin{matrix}1 & 0 \\ \frac{1}{jX 0} & 1\end{matrix}\right]$ Eqn. 10 where the matrix parameters *A₁, B₁, C₁, D₁* form the ABCD matrix for the positive sequence. As mentioned above, the ABCD matrix for the negative sequence is equal to the ABCD matrix for the positive sequence.
Correspondingly, the matrix parameters *A₀, B₀, C₀, D₀* form the ABCD matrix for zero sequence. It can be noted that the C parameter, 1/jX, is an admittance.

The shunt reactor 116 can have a fixed reactor impedance. However, alternatively it can have a variable impedance, which depends on the used tap position for the variable shunt reactor. Such a variable impedance is readily coped with in the matrix operations. Typically, the reactor values for different tap positions are obtainable from a predetermined table.

It is to be noted that other impedance or admittance components can be modelled in a similar way, such as e.g. series capacitors connected in series with the transmission line 101, as will be understood by the person skilled in the art from the present description. Thus, as illustrated in Fig. 4, the power transmission line model 150 may include series capacitors 140, which may be modelled by corresponding ABCD matrices for positive and zero sequence according to: $\left[\begin{matrix}A 1 & B 1 \\ C 1 & D 1\end{matrix}\right] = \left[\begin{matrix}1 & \frac{1}{j ∗ 2 ∗ π ∗ f ∗ C} \\ 0 & 1\end{matrix}\right]$ Eqn. 11 $\left[\begin{matrix}A 0 & B 0 \\ C 0 & D 0\end{matrix}\right] = \left[\begin{matrix}1 & \frac{1}{j ∗ 2 ∗ π ∗ f ∗ C} \\ 0 & 1\end{matrix}\right]$ Eqn. 12

Referring to the present method, as mentioned above, when estimating the voltages and currents at the remote position RP, it is advantageous to take into account both properties of the power transmission line 101 as such, and properties of external elements, like the shunt reactors 116 and the series capacitors 140, which are associated with the power transmission line 101 and affects its behaviour. With the matrix notation this can be done by matrix multiplication, as mentioned above for interconnected two-port networks. Thus, by denoting the ABCD matrix for the power transmission line as such MTL, the first matrix MF, the second matrix MS, and the resulting matrix MRP, since it contains parameters for the remote position RP, and further denoting the shunt reactor matrix MSR, and the series capacitor matrix MSC, the following equation can be employed: $MRP = MF * MS = MTL * MSR * MSC * MS$ Eqn. 13

In order to determine the individual parameters of the matrices, properties associated with the power transmission line 101, and more particularly the part of the power transmission line constituting the protected line, which may very well constitute the whole length of the transmission line between two main connection sites, such as at a wind farm and at the grid, are obtainable from a table, or some other suitable representation, which has been set up in advance. For long transmission lines such a table may contain values for several different sections of the transmission line, simply because it is often built in sections having different Z and Y values, such as a combination of OHL and cable sections. Often, the section values can be added to a total value for the whole length, but if not, a separate ABCD matrix can be determined for each section. These section matrices are then multiplied with each other to form the single matrix MTL for the power transmission line, or they are used separately. Similarly, by multiplying this transmission line matrix MTL with the shunt reactor matrix MSR and the series capacitor matrix MSC finally the first matrix MF representing the whole protected object, i.e. all relevant sections and associated shunt parameters and series parameters, is generated. It should be noted that the matrices are multiplied in the order that the physical parts that they represent occur along the power transmission line.

The table of properties can hold, for example, resistance, reactance, and capacitance, all for positive sequence as well as zero sequence. By applying the above equations Eqn. 5 - Eqn. 8, the matrix for the power transmission line/protected line MTL can be determined.

For the/each shunt reactor 116 predetermined values of reactance are obtained as predetermined data, or reactive power and voltage are noted, from which the reactance is easily obtained. Then the shunt reactor matrices MSR for positive and zero sequences are determined according to the above equations Eqns. 9 and 10.

Then, for positive and zero sequences, the first matrix MF can be determined as the product of the respective transmission line matrix MTL, shunt reactor matrix MSR, and the series capacitor matrix MSC, i.e. MF=MTL*MSR. Finally, for each sequence, the remote position matrix MRP is determined as the product of the first matrix MF and the second matrix MS, i.e. MRP=MF*MS. Recalling that the first matrix is the same for the positive and negative sequences, the following equations will provide the final estimates of the voltages and currents at the remote position for all sequences: $\left[\begin{matrix}{U}_{1} @ RP \\ {I}_{1} @ RP\end{matrix}\right] = \left[\begin{matrix}MD 1 & - MB 1 \\ - MC 1 & MA 1\end{matrix}\right] ∗ \left[\begin{matrix}{U}_{1} \\ {I}_{1}\end{matrix}\right]$ Eqn. 14 $\left[\begin{matrix}{U}_{2} @ RP \\ {I}_{2} @ RP\end{matrix}\right] = \left[\begin{matrix}MD 1 & - MB 1 \\ - MC 1 & MA 1\end{matrix}\right] ∗ \left[\begin{matrix}{U}_{2} \\ {I}_{2}\end{matrix}\right]$ Eqn. 15 $\left[\begin{matrix}{U}_{0} @ RP \\ {I}_{0} @ RP\end{matrix}\right] = \left[\begin{matrix}MD 0 & - MB 0 \\ - MC 0 & MA 0\end{matrix}\right] ∗ \left[\begin{matrix}{U}_{0} \\ I 0\end{matrix}\right]$ Eqn. 16

However, although the estimation of voltages and currents at RP is accurate, and better than previous estimations not taking shunt factors into account, it is still an approximation based on mathematical models. Therefore, the estimated sequence voltage phasors do not quite mirror the actual behaviour, but the result is accompanied by some effects which have to be considered in the fault determination.

As described above, the method further comprises measuring, at the remote position RP, that is by means of the remote IED 112, phase voltages and phase currents *U_{M}@RP, I_{M}@RP.* Data representing the phase voltages and phase currents are sent on the communication link 115 to the local IED 111. Like with the local phase voltages and local phase currents, phasors are determined and referred to as measured remote current phasors and measured remote voltage phasors. Sequence currents and sequence voltages thereof are also determined. The measured remote sequence voltage phasors and measured remote sequence current phasors are denoted *U_{M1}@RP, U_{M2}@RP, U_{M0}@RP, I_{M1}@RP, I_{M2}@RP, I_{M0}@RP.* The operation of determining whether a fault has occurred or not comprises comparing the measured remote sequence voltage phasors *U_{M1}@RP, U_{M2}@RP, U_{M0}@RP,* with the estimated remote sequence voltage phasors *U₁@RP, U₂@RP, U₀@RP,* comparing the corresponding currents, or both.

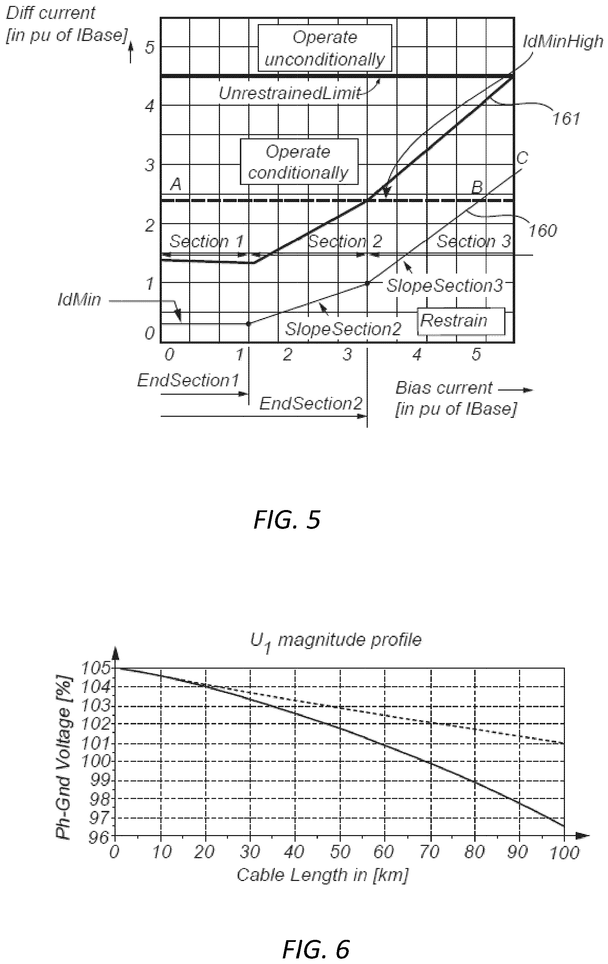

As an example, with reference to Fig. 5, a current based line differential protection can be formed which performs comparisons based on the estimated remote current phasors *I_Est@RP* and the measured remote current phasors *I_Mesured@RP.* The estimated remote current phasors are generated from the estimated sequence current phasors by reversely applying equations 1 and 2 above. This comparison may for example be done for phase A as follows. The differential current *I_Diff_A* and a bias current *I_Bias_A* are determined according to: $\begin{matrix}I _ Diff _ A = IA _ Est @ RP + IA _ Mesured @ RP \\ I _ Bias _ A = max \left(IA_Est@RP; IA_Mesured@RP\right)\end{matrix}$ Eqn. 15

These currents may be entered into an operate-restraint characteristic, as shown in Fig. 5. The operate-restraint characteristic contains a threshold current, called IdMin in the diagram, which marks the border for tripping illustrated with the lower curve 160. Below the threshold current IdMin no tripping of any breaker 105-108 is initiated, in a restrain area, i.e. the state of the AC power transmission system 100 remains. Above the threshold current IdMin tripping is executed, in an operation area, and the current is broken through the power transmission line of the protected object 114 is broken. However, the operation area may be divided in a lower subarea above but in the vicinity of the threshold current where the decision to execute the tripping may rest on one or more additional conditions, and an upper subarea above the lower subarea where the tripping is unconditionally executed. By means of the present method, where the shunt factor is used in the estimation of currents at the remote position RP, it is possible to use a lower threshold than in the prior art where the shunt factor was not used, but only the line impedance. This is because the estimation is more accurate. Consequently, the method is more sensitive than the prior art methods without causing more false fault decisions. In Fig. 5 the upper graph 161 illustrates that in the prior art methods it is necessary to increase the level of the threshold current IdMin in order not to cause false trippings, which are a result of the lower accuracy. On the other hand, when a fault actually occurs a higher threshold current IdMin causes a longer time during which the short current can flow and increase, thereby rendering a higher risk of causing damage to the AC power transmission system 100.

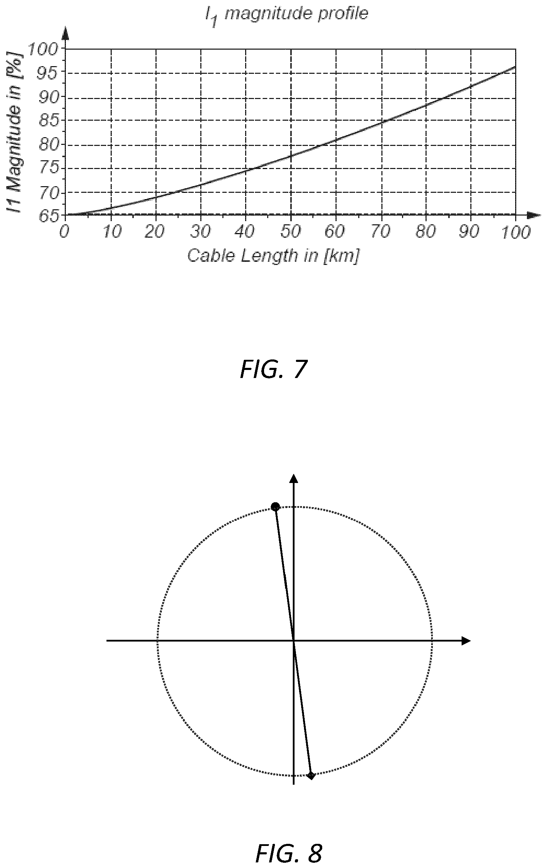

The accuracy difference between the prior art method only taking the line impedance into account is illustrated in figures 6 and 7. The error of the prior art method increases with the length of the power transmission line, in particular when the transmission is a cable, while the error is less for power transmission lines being overhead lines OHL. Figures 6 and 7 illustrate, by a representative example, the impact of adding the shunt factor into the matrix calculations for estimating the voltages and currents at the remote position RP. In figure 6 the y axis represents the phase to ground voltage represented by the positive sequence voltage U₁ in percent of a base voltage corresponding the rated voltage. It can be seen that for the prior art method, the upper graph shown by a broken line, the estimated voltage decreases from 105 % to just below 101 % from a cable length close to 0 km up to a cable length of 100 km, while for the present method the estimated current decreases from 105 % to just below 97 % for the same lengths of the cable. Consequently, there is a difference of 4 percentage points, which is a difference small enough to be ignorable. On the other hand, the difference for the current is certainly significant, as can be seen in figure 7. When using the prior art method, the estimated current for any length of the cable is the same as the current for a cable close to 0 km long, being 65 % of the base current, i.e. the rated current. However, when using the present method the estimated current increases with the length of the cable up to more than 95 % of the base current for a cable length of 100 km. This effect is due to the charging current compensation, compensating for charging currents along the power transmission line 101, that is obtained by means of the present method.

As regards the determination about whether the fault is a true fault or a false fault, having obtained the estimated remote positive sequence current phasor it is possible to compare it with the measured remote positive sequence current phasor, which is calculated according to Eqn. 1 by means of the measured remote current phasors for the three phases. The comparison may be done by means of calculating a phasor sum and a magnitude difference. As well-known to the person skilled in the art a phasor notation is a vector notation of a magnitude and a phase angle, such as *Iₘ* ∠ *ϕ.* The estimated remote positive sequence current phasor may be denoted as *I₁_RmtE,* and the measured remote positive sequence current phasor may be denoted as *I₁_Rmt.* Then the phasor sum may be expressed as: $ΣP = \left|{I}_{1}_RmtE+{I}_{1}_Rmt\right|$ Eqn. 17

The magnitude difference may be expressed as: $ΔM = \left|{I}_{1}_RmtE\right| - \left|{I}_{1}_RmtE\right|$ Eqn. 18

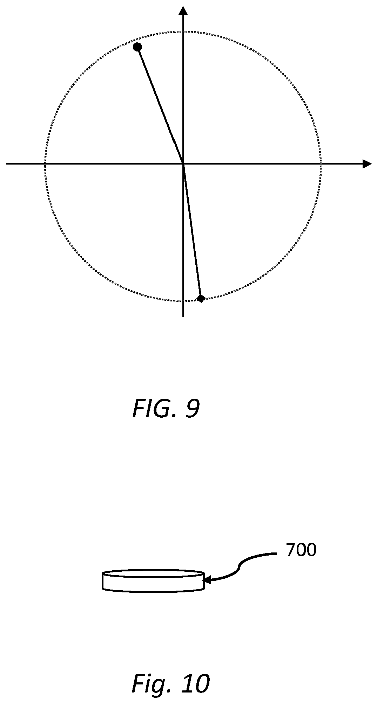

As an example, having measured the remote phase currents with the remote IED 112 at a point of time where there is no channel asymmetry and no power transmission line fault, and having calculated the corresponding measured remote positive sequence current phasor *I₁_Rmt* and having calculated the estimated remote positive sequence current phasor *I₁_RmtE* with the local IED 111 for the same point in time, a plot of those may look as in Fig. 8. The measured remote positive sequence current phasor *I₁_Rmt* is indicated with a circle, and the estimated remote positive sequence current phasor *I₁_RmtE* is indicated with a rhomb. As can be seen the measured positive sequence remote current phasor *I₁_Rmt* has the same magnitude as the estimated positive sequence remote current phasor *I₁_RmtE,* and their phase angles differ exactly 180 degrees. Consequently, the phasor sum *ΣP* is zero and the magnitude difference *ΔM* is zero as well. On the other hand, at the occurrence of a channel asymmetry the relation between those currents will change, as illustrated in Fig. 9. In this case, at a different point of time than in the above case, the measured positive sequence remote current phasor *I₁_Rmt* has a different phase angle than in the first graph, and the phase angle difference deviates significantly from 180 degrees. Similarly, the magnitude of the measured positive sequence remote current phasor *I₁_Rmt* deviates insignificantly from the magnitude of the estimated positive sequence remote current phasor *I₁_RmtE.* By determining the phasor sum *ΣP* and the magnitude difference *ΔM*, it can be concluded that the phasor sum *ΣP* exceeds a first threshold, while the magnitude difference *ΔM* is below a second threshold. Consequently, it is determined that there is a significant channel asymmetry. This result activates a blocking operation which prevents the local IED 111 from triggering a breaker 107, in case it would have determined, as described above, that a critical fault has occurred on the power transmission line 101 causing such an operation. In other words, it has been determined that the fault is not a true fault but a false fault.

As mentioned above, in the ideal case the thresholds could be set to zero, while in practise a likelihood of minor errors should be taken into account. However, by logging the results, as also explained above, it will be possible to use adaptable thresholds. Thus, for instance, initially the first and second thresholds may be chosen to have values with an initial margin to expected possible deviations, and over time the logged results may show that the deviations are smaller than expected. Then the first and second thresholds may be lowered to make the method more sensitive to detecting a false fault caused by channel asymmetry.

Furthermore, the method may include determining an amount of channel asymmetry on basis of deviation of the phase angle difference, and logging data regarding that amount. This data may be provided to the end user who, thereby, can monitor different aspects of the channel asymmetry, e.g. how the channel asymmetry changes over months or years.

As noted above, for the present method only the positive sequence current is used. However, for sake of completeness, and since the method is actually related to the differential protection, where more than one sequence is often used for detecting different kinds of faults, above generally calculations are presented for all three sequences.

Figure 10 most schematically illustrates that as an aspect of the present disclosure, there is provided a computer program product 700 comprising instructions which, when downloaded into the IED 111 cause the IED 111 to carry out the operations of the above method.

While the present disclosure has been illustrated and described in detail in the drawings and foregoing description, such illustration and description are to be considered illustrative or exemplary and not restrictive.

Although features and elements are described above in particular combinations, each feature or element can be used alone without the other features and elements or in various combinations with or without other features and elements.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain features are recited in mutually different dependent claims does not indicate that a combination of these features cannot be used to advantage. Any reference signs in the claims should not be construed as limiting the scope.

## Claims

1. A fault detection method for a power transmission line (101) in an alternating current, AC, power transmission system (100), the method comprising:
- measuring, at a local position of the power transmission line, phase voltages and phase currents, and determining phasors thereof as measured local voltage phasors and measured local current phasors;
- obtaining transmission properties for the power transmission line from the local position to a remote position at a distance from the local position and for associated devices, wherein the transmission properties comprise series parameters, shunt parameters, and the distance from the local position to the remote position;
- estimating, for the remote position, estimated remote voltage phasors and estimated remote current phasors on basis of the measured local voltage phasors, the measured local current phasors, and the transmission properties;
- receiving, at the local position, via a communication link (115), data relating to remote phase currents, which have been measured at the remote position, and determining the phasors thereof as measured remote current phasors;
- determining whether a fault has occurred or not on basis of at least one of a combination of the estimated remote current phasors and the measured remote current phasors and a combination of the estimated remote voltage phasors and the measured remote voltage phasors; **characterised by**:
- when it is determined that a fault has occurred, determining whether the fault is a true fault or a false fault, comprising:
∘ determining a measured remote positive sequence current phasor from the measured remote current phasors;
∘ determining an estimated remote positive sequence current phasor from the estimated remote current phasors;
∘ comparing a first phase angle and a first magnitude of the estimated remote positive sequence current phasor with a second phase angle and a second magnitude of the measured remote positive sequence current phasor;
∘ determining, on basis of the comparison, whether there is a significant channel asymmetry on the communication link; and
∘ determining that the fault is a false fault if there is a significant channel asymmetry.

2. The method according to claim 1, wherein the series parameters comprise a line impedance for the power transmission line.

3. The method according to claim 2, wherein the shunt parameters comprise at least one of a shunt factor directly between the power transmission line and ground, and a shunt factor of at least one shunt reactor comprised in the associated devices and connected with the power transmission line.

4. The method according to claim 3, wherein the estimation of estimated remote voltage phasors and estimated remote current phasors comprises determining a first matrix having matrix parameters determined on basis of the distance, the line impedance and the shunt factor, and multiplying the first matrix with a second matrix having matrix parameters based on the measured local voltage phasors and measured local current phasors.

5. The method according to claim 4, wherein the associated devices comprise at least one series capacitor, wherein the series parameters comprise a series capacitance of the at least one series capacitor, and wherein the matrix parameters of the first matrix are additionally based on the series capacitance.

6. The method according to any one of the preceding claims, said determining whether a fault has occurred or not comprising determining an estimated remote positive sequence current phasor of the estimated remote current phasors.

7. The method according to any one of the preceding claims, comprising preventing, when it has been determined that the fault is a false fault, triggering of a breaker of the power transmission line.

8. The method according to any one of the preceding claims, said determining whether there is a significant channel asymmetry on the communication link comprising determining that there is a significant channel asymmetry if a phase angle difference between the first and second phase angles deviates more than a predetermined extent from 180 degrees while a magnitude difference between the first and second magnitudes deviates less than a predetermined extent from zero.

9. The method according to claim 8, comprising determining an amount of channel asymmetry on basis of deviation of the phase angle difference, and logging data regarding that amount.

10. The method according to any one of the preceding claims, said comparing comprising determining a phasor sum of the estimated remote positive sequence current phasor and the measured remote positive sequence current phasor, and determining a magnitude difference between the first and second magnitudes, and said determining whether there is a significant channel asymmetry comprising determining that there is a significant channel asymmetry if the phasor sum exceeds a first threshold while the magnitude difference is below a second threshold.

11. The method according to claim 10, comprising logging data regarding results of the determinations of the phasor sum and the magnitude difference and adapting the first and second thresholds on basis of the logged data.

12. A fault detection system for an alternating current, AC, power transmission system (100) comprising a power transmission line (101), the fault detection system comprising at least one intelligent electric device, IED, connectable with the power transmission line, wherein a local IED (111) of the at least one IED is configured to:
- measure, at a local position of the power transmission line, phase voltages and phase currents, and determine the phasors thereof as measured local voltage phasors and measured local current phasors;
- obtain transmission properties for the power transmission line from the local position to a remote position at a distance from the local position and for associated devices, wherein the transmission properties comprise series parameters, shunt parameters, and the distance from the local position to the remote position;
- estimate, for the remote position, estimated remote voltage phasors and estimated remote current phasors on basis of the measured local voltage phasors, the measured local current phasors, and the transmission properties;
- receive, at the local position, via a communication link, data relating to remote phase currents, which have been measured at the remote position, and determine the phasors thereof as measured remote current phasors;
- determine whether a fault has occurred or not on basis of at least one of a combination of the estimated remote current phasors and the measured remote current phasors and a combination of the estimated remote voltage phasors and the measured remote voltage phasors; **characterised in that** the at least one IED is configured to:
- determine, when it is determined that a fault has occurred, whether the fault is a true fault or a false fault, comprising:
∘ determining a measured remote positive sequence current phasor from the measured remote current phasors;
∘ determining an estimated remote positive sequence current phasor from the estimated remote current phasors;
∘ comparing a first phase angle and a first magnitude of the estimated remote positive sequence current phasor with a second phase angle and a second magnitude of the measured remote positive sequence current phasor;
∘ determining, on basis of the comparison, whether there is a significant channel asymmetry on the communication link; and
∘ determine that the fault is a false fault if there is a significant channel asymmetry.

13. The fault detection system according to claim 12, wherein the shunt parameters comprise at least one of a shunt factor directly between the power transmission line and ground, and a shunt factor of at least one shunt reactor (116) comprised in the associated devices and connected with the power transmission line (101).

14. The fault detection system according to claim 13, wherein a remote IED (112) of said at least one IED positioned at the remote position is configured to measure the remote phase currents.

15. A computer program product comprising instructions which, when downloaded into an intelligent electronic device, IED, connectable to a power transmission line (101) of an alternating current, AC, power transmission system (100), causes the intelligent electronic device to carry out operations comprising:
measuring, at a local position of the power transmission line, phase voltages and phase currents, and determining the phasors thereof as measured local voltage phasors and measured local current phasors;
- obtaining transmission properties for the power transmission line from the local position to a remote position at a distance from the local position and for associated devices, wherein the transmission properties comprise series parameters, shunt parameters, and the distance from the local position to the remote position;
- estimating, for the remote position, estimated remote voltage phasors and estimated remote current phasors on basis of the measured local voltage phasors, the measured local current phasors, and the transmission properties;
- receiving, at the local position, via a communication link, data relating to remote phase currents, which have been measured at the remote position, and determining the phasors thereof as measured remote current phasors;
- determining whether a fault has occurred or not on basis of at least one of a combination of the estimated remote current phasors and the measured remote current phasors and a combination of the estimated remote voltage phasors and the measured remote voltage phasors; **characterised by**:
- when it is determined that a fault has occurred, determining whether the fault is a true fault or a false fault, comprising:
∘ determining a measured remote positive sequence current phasor from the measured remote current phasors;
∘ determining an estimated remote positive sequence current phasor from the estimated remote current phasors;
∘ comparing a first phase angle and a first magnitude of the estimated remote positive sequence current phasor with a second phase angle and a second magnitude of the measured remote positive sequence current phasor;
∘ determining, on basis of the comparison, whether there is a significant channel asymmetry on the communication link; and
∘ determining that the fault is a false fault if there is a significant channel asymmetry.

## Patentansprüche

1. Fehlerdetektionsverfahren für eine Leistungsübertragungsleitung (101) in einem Wechselstrom-Leistungsübertragungssystem (100), wobei das Verfahren Folgendes umfasst:
- Messen von Phasenspannungen und Phasenströmen an einer lokalen Position der Leistungsübertragungsleitung und Bestimmen von Phasoren davon als gemessene lokale Spannungsphasoren und gemessene lokale Stromphasoren;
- Erhalten von Übertragungseigenschaften für die Leistungsübertragungsleitung von der lokalen Position zu einer entfernten Position in einem Abstand von der lokalen Position und für assoziierte Vorrichtungen, wobei die Übertragungseigenschaften Serienparameter, Querparameter und den Abstand von der lokalen Position zu der entfernten Position umfassen;
- Schätzen der geschätzten entfernten Spannungsphasoren und der geschätzten entfernten Stromphasoren für die entfernte Position auf der Grundlage der gemessenen lokalen Spannungsphasoren, der gemessenen lokalen Stromphasoren und der Übertragungseigenschaften;
- Empfangen von Daten über entfernte Phasenströme, die an der entfernten Position gemessen wurden, an der lokalen Position über eine Kommunikationsverbindung (115) und Bestimmen von Phasoren davon als gemessene entfernte Stromphasoren;
- Bestimmen, ob ein Fehler aufgetreten ist oder nicht, basierend auf einer Kombination der geschätzten entfernten Stromphasoren und der gemessenen entfernten Stromphasoren und/oder einer Kombination der geschätzten entfernten Spannungsphasoren und der gemessenen entfernten Spannungsphasoren; **gekennzeichnet durch**:
- wenn bestimmt wird, dass ein Fehler aufgetreten ist, Bestimmen, ob der Fehler ein echter Fehler oder ein falscher Fehler ist, umfassend:
∘ Bestimmen eines gemessenen entfernten positiven Sequenzstromphasors aus den gemessenen entfernten Stromphasoren;
∘ Bestimmen eines geschätzten entfernten positiven Sequenzstromphasors aus den geschätzten entfernten Stromphasoren;
∘ Vergleichen eines ersten Phasenwinkels und eines ersten Betrags des geschätzten entfernten positiven Sequenzstromphasors mit einem zweiten Phasenwinkel und einem zweiten Betrag des gemessenen entfernten positiven Sequenzstromphasors;
∘ Bestimmen basierend auf dem Vergleich, ob es eine signifikante Kanalasymmetrie auf der Kommunikationsverbindung gibt; und
∘ Bestimmen, dass der Fehler ein falscher Fehler ist, wenn eine signifikante Kanalasymmetrie vorliegt.

2. Verfahren nach Anspruch 1, wobei die Serienparameter eine Leitungsimpedanz für die Leistungsübertragungsleitung umfassen.

3. Verfahren nach Anspruch 2, wobei die Querparameter einen Querfaktor direkt zwischen der Leistungsübertragungsleitung und Masse und/oder einen Querfaktor mindestens einer Nebenschlussdrossel umfassen, die in den assoziierten Vorrichtungen enthalten ist und mit der Leistungsübertragungsleitung verbunden ist.

4. Verfahren nach Anspruch 3, wobei die Schätzung geschätzter entfernter Spannungsphasoren und geschätzter entfernter Stromphasoren ein Bestimmen einer ersten Matrix mit Matrixparametern, die basierend auf dem Abstand, der Leitungsimpedanz und dem Querfaktor bestimmt werden, und ein Multiplizieren der ersten Matrix mit einer zweiten Matrix mit Matrixparametern, die auf den gemessenen lokalen Spannungsphasoren und gemessenen lokalen Stromphasoren basieren, umfasst.

5. Verfahren nach Anspruch 4, wobei die assoziierten Vorrichtungen mindestens einen Serienkondensator umfassen, wobei die Serienparameter eine Serienkapazität des mindestens einen Serienkondensators umfassen und wobei die Matrixparameter der ersten Matrix zusätzlich auf der Serienkapazität basieren.

6. Verfahren nach einem der vorhergehenden Ansprüche, wobei das Bestimmen, ob ein Fehler aufgetreten ist oder nicht, ein Bestimmen eines geschätzten entfernten positiven Sequenzstromphasors der geschätzten entfernten Stromphasoren umfasst.

7. Verfahren nach einem der vorhergehenden Ansprüche, das ein Verhindern eines Auslösens eines Leistungsschalters der Leistungsübertragungsleitung umfasst, wenn bestimmt wurde, dass der Fehler ein falscher Fehler ist.

8. Verfahren nach einem der vorhergehenden Ansprüche, wobei das Bestimmen, ob es eine signifikante Kanalasymmetrie auf der Kommunikationsverbindung gibt, ein Bestimmen, dass es eine signifikante Kanalasymmetrie gibt, wenn eine Phasenwinkeldifferenz zwischen dem ersten und dem zweiten Phasenwinkel um mehr als ein vorbestimmtes Ausmaß von 180 Grad abweicht, während eine Betragsdifferenz zwischen dem ersten und dem zweiten Betrag weniger als um ein vorbestimmtes Ausmaß von null abweicht, umfasst.

9. Verfahren nach Anspruch 8, das ein Bestimmen eines Ausmaßes einer Kanalasymmetrie auf Basis einer Abweichung der Phasenwinkeldifferenz und ein Protokollieren von Daten bezüglich dieses Ausmaßes umfasst.

10. Verfahren nach einem der vorhergehenden Ansprüche, wobei das Vergleichen ein Bestimmen einer Phasorsumme des geschätzten entfernten positiven Sequenzstromphasors und des gemessenen entfernten positiven Sequenzstromphasors und ein Bestimmen einer Betragsdifferenz zwischen dem ersten und dem zweiten Betrag umfasst und das Bestimmen, ob es eine signifikante Kanalasymmetrie gibt, ein Bestimmen , dass es eine signifikante Kanalasymmetrie gibt, wenn die Phasorsumme eine erste Schwelle überschreitet, während die Betragsdifferenz unter einer zweiten Schwelle liegt, umfasst.

11. Verfahren nach Anspruch 10, das ein Protokollieren von Daten bezüglich Ergebnissen der Bestimmungen der Phasorsumme und der Betragsdifferenz und ein Anpassen der ersten und zweiten Schwelle auf Basis der protokollierten Daten umfasst.

12. Fehlerdetektionssystem für ein Wechselstrom-Leistungsübertragungssystem (100), das eine Leistungsübertragungsleitung (101) umfasst, wobei das Fehlerdetektionssystem mindestens eine intelligente elektrische Vorrichtung, IED, umfasst, die mit der Leistungsübertragungsleitung verbindbar ist, wobei eine lokale IED (111) der mindestens einen IED zu Folgendem ausgelegt ist:
- Messen von Phasenspannungen und Phasenströmen an einer lokalen Position der Leistungsübertragungsleitung und Bestimmen von Phasoren davon als gemessene lokale Spannungsphasoren und gemessene lokale Stromphasoren;
- Erhalten von Übertragungseigenschaften für die Leistungsübertragungsleitung von der lokalen Position zu einer entfernten Position in einem Abstand von der lokalen Position und für assoziierte Vorrichtungen, wobei die Übertragungseigenschaften Serienparameter, Querparameter und den Abstand von der lokalen Position zu der entfernten Position umfassen;
- Schätzen der geschätzten entfernten Spannungsphasoren und der geschätzten entfernten Stromphasoren für die entfernte Position auf der Grundlage der gemessenen lokalen Spannungsphasoren, der gemessenen lokalen Stromphasoren und der Übertragungseigenschaften;
- Empfangen von Daten über entfernte Phasenströme, die an der entfernten Position gemessen wurden, an der lokalen Position über eine Kommunikationsverbindung und Bestimmen von Phasoren davon als gemessene entfernte Stromphasoren;
- Bestimmen, ob ein Fehler aufgetreten ist oder nicht, basierend auf einer Kombination der geschätzten entfernten Stromphasoren und der gemessenen entfernten Stromphasoren und/oder einer Kombination der geschätzten entfernten Spannungsphasoren und der gemessenen entfernten Spannungsphasoren; **dadurch gekennzeichnet, dass** die mindestens eine IED zu Folgendem ausgelegt ist:
- wenn bestimmt wird, dass ein Fehler aufgetreten ist, Bestimmen, ob der Fehler ein echter Fehler oder ein falscher Fehler ist, umfassend:
∘ Bestimmen eines gemessenen entfernten positiven Sequenzstromphasors aus den gemessenen entfernten Stromphasoren;
∘ Bestimmen eines geschätzten entfernten positiven Sequenzstromphasors aus den geschätzten entfernten Stromphasoren;
∘ Vergleichen eines ersten Phasenwinkels und eines ersten Betrags des geschätzten entfernten positiven Sequenzstromphasors mit einem zweiten Phasenwinkel und einem zweiten Betrag des gemessenen entfernten positiven Sequenzstromphasors;
∘ Bestimmen basierend auf dem Vergleich, ob es eine signifikante Kanalasymmetrie auf der Kommunikationsverbindung gibt; und
∘ Bestimmen, dass der Fehler ein falscher Fehler ist, wenn eine signifikante Kanalasymmetrie vorliegt.

13. Fehlerdetektionssystem nach Anspruch 12, wobei die Querparameter einen Querfaktor direkt zwischen der Leistungsübertragungsleitung und Masse und/oder einen Querfaktor mindestens einer Nebenschlussdrossel (116) umfassen, die in den assoziierten Vorrichtungen enthalten ist und mit der Leistungsübertragungsleitung (101) verbunden ist.

14. Fehlerdetektionssystem nach Anspruch 13, wobei eine entfernte IED (112) der mindestens einen IED, die an der entfernten Position positioniert ist, dazu ausgelegt ist, die entfernten Phasenströme zu messen.

15. Computerprogrammprodukt, das Anweisungen umfasst, die, wenn sie in eine intelligente elektronische Vorrichtung, IED, heruntergeladen werden, die mit einer Leistungsübertragungsleitung (101) eines Wechselstrom-Leistungsübertragungssystems (100) verbindbar ist, bewirken, dass die intelligente elektronische Vorrichtung Operationen ausführt, die Folgendes umfassen:
Messen von Phasenspannungen und Phasenströmen an einer lokalen Position der Leistungsübertragungsleitung und Bestimmen von Phasoren davon als gemessene lokale Spannungsphasoren und gemessene lokale Stromphasoren;
- Erhalten von Übertragungseigenschaften für die Leistungsübertragungsleitung von der lokalen Position zu einer entfernten Position in einem Abstand von der lokalen Position und für assoziierte Vorrichtungen, wobei die Übertragungseigenschaften Serienparameter, Querparameter und den Abstand von der lokalen Position zu der entfernten Position umfassen;
- Schätzen der geschätzten entfernten Spannungsphasoren und der geschätzten entfernten Stromphasoren für die entfernte Position auf der Grundlage der gemessenen lokalen Spannungsphasoren, der gemessenen lokalen Stromphasoren und der Übertragungseigenschaften;
- Empfangen von Daten über entfernte Phasenströme, die an der entfernten Position gemessen wurden, an der lokalen Position über eine Kommunikationsverbindung und Bestimmen von Phasoren davon als gemessene entfernte Stromphasoren;
- Bestimmen, ob ein Fehler aufgetreten ist oder nicht, basierend auf einer Kombination der geschätzten entfernten Stromphasoren und der gemessenen entfernten Stromphasoren und/oder einer Kombination der geschätzten entfernten Spannungsphasoren und der gemessenen entfernten Spannungsphasoren; **gekennzeichnet durch**:
- wenn bestimmt wird, dass ein Fehler aufgetreten ist, Bestimmen, ob der Fehler ein echter Fehler oder ein falscher Fehler ist, umfassend:
∘ Bestimmen eines gemessenen entfernten positiven Sequenzstromphasors aus den gemessenen entfernten Stromphasoren;
∘ Bestimmen eines geschätzten entfernten positiven Sequenzstromphasors aus den geschätzten entfernten Stromphasoren;
∘ Vergleichen eines ersten Phasenwinkels und eines ersten Betrags des geschätzten entfernten positiven Sequenzstromphasors mit einem zweiten Phasenwinkel und einem zweiten Betrag des gemessenen entfernten positiven Sequenzstromphasors;
∘ Bestimmen basierend auf dem Vergleich, ob es eine signifikante Kanalasymmetrie auf der Kommunikationsverbindung gibt; und
∘ Bestimmen, dass der Fehler ein falscher Fehler ist, wenn eine signifikante Kanalasymmetrie vorliegt.

## Revendications

1. Procédé de détection de défaut pour une ligne de transmission d'énergie (101) dans un système de transmission d'énergie (100) à courant alternatif, CA, le procédé comprenant :
- la mesure, à un emplacement local de la ligne de transmission d'énergie, de tensions de phase et de courants de phase, et la détermination de leurs phaseurs en tant que phaseurs de tension locaux mesurés et phaseurs de courant locaux mesurés ;
- l'obtention de propriétés de transmission pour la ligne de transmission d'énergie de la position locale vers une position distante à distance de la position locale et pour des dispositifs associés, les propriétés de transmission comprenant des paramètres de série, des paramètres de dérivation, et la distance de la position locale à la position distante ;
- l'estimation, pour la position distante, de phaseurs de tension distants estimés et de phaseurs de courant distants estimés sur la base des phaseurs de tension locaux mesurés, des phaseurs de courant locaux mesurés et des propriétés de transmission ;
- la réception, à la position locale, par l'intermédiaire d'une liaison de communication (115), de données relatives à des courants de phase distants, qui ont été mesurés à la position distante, et la détermination de leurs phaseurs en tant que phaseurs de courant distants mesurés ;
- la détermination si un défaut s'est produit ou non sur la base d'au moins l'une d'une combinaison des phaseurs de courant distants estimés et des phaseurs de courant distants mesurés et d'une combinaison des phaseurs de tension distants estimés et des phaseurs de tension distants mesurés ; **caractérisé par** :
- lorsqu'il est déterminé qu'un défaut a eu lieu, la détermination si le défaut est un vrai défaut ou un faux défaut, comprenant :
∘ la détermination d'un phaseur de courant de séquence positive distant mesuré à partir des phaseurs de courant distants mesurés ;
∘ la détermination d'un phaseur de courant de séquence positive distant estimé à partir des phaseurs de courant distants estimés ;
∘ la comparaison d'un premier angle de phase et d'une première amplitude du phaseur de courant de séquence positive distant estimé avec un second angle de phase et une seconde amplitude du phaseur de courant de séquence positive distant mesuré ;
∘ la détermination sur la base de la comparaison s'il existe une asymétrie de canal significative sur le lien de communication ; et
∘ la détermination que le défaut est un faux défaut s'il existe une asymétrie de canal significative.

2. Procédé selon la revendication 1, les paramètres de série comprenant une impédance de ligne pour la ligne de transmission d'énergie.

3. Procédé selon la revendication 2, les paramètres de dérivation comprenant au moins l'un d'un facteur de dérivation directement entre la ligne de transmission d'énergie et la terre, et d'un facteur de dérivation d'au moins un réacteur de dérivation compris dans les dispositifs associés et connecté à la ligne de transmission d'énergie.

4. Procédé selon la revendication 3, l'estimation de phaseurs de tension distants estimés et de phaseurs de courant distants estimés comprenant la détermination d'une première matrice ayant des paramètres de matrice déterminés sur la base de la distance, de l'impédance de ligne et du facteur de dérivation, et la multiplication de la première matrice avec une seconde matrice ayant des paramètres de matrice basés sur les phaseurs de tension locaux mesurés et les phaseurs de courant locaux mesurés.

5. Procédé selon la revendication 4, les dispositifs associés comprenant au moins un condensateur série, les paramètres de série comprenant une capacité série de l'au moins un condensateur série, et les paramètres de matrice de la première matrice étant en outre basés sur la capacité série.

6. Procédé selon l'une quelconque des revendications précédentes, ladite détermination si une défaillance s'est produite ou non comprenant la détermination d'un phaseur de courant de séquence positive distant estimé des phaseurs de courant distants estimés.

7. Procédé selon l'une quelconque des revendications précédentes, comprenant l'étape consistant à empêcher, lorsqu'il a été déterminé que le défaut est un faux défaut, le déclenchement d'un disjoncteur de la ligne de transmission d'énergie.

8. Procédé selon l'une quelconque des revendications précédentes, ladite détermination s'il existe une asymétrie de canal significative sur la liaison de communication comprenant la détermination qu'il existe une asymétrie de canal significative si une différence d'angle de phase entre les premier et second angles de phase s'écarte de plus d'une étendue prédéterminée de 180 degrés tandis qu'une différence d'amplitude entre les première et seconde amplitudes s'écarte de moins d'une étendue prédéterminée de zéro.

9. Procédé selon la revendication 8, comprenant la détermination d'une quantité d'asymétrie de canal sur la base de l'écart de la différence d'angle de phase, et l'enregistrement de données concernant cette quantité.

10. Procédé selon l'une quelconque des revendications précédentes, ladite comparaison comprenant la détermination d'une somme de phaseur du phaseur de courant de séquence positive distant estimé et du phaseur de courant de séquence positive distant mesuré, et la détermination d'une différence d'amplitude entre les première et seconde amplitudes, et ladite détermination s'il existe une asymétrie de canal significative comprenant la détermination qu'il existe une asymétrie de canal significative si la somme de phaseur dépasse un premier seuil tandis que la différence d'amplitude est inférieure à un second seuil.

11. Procédé selon la revendication 10, comprenant l'enregistrement de données concernant les résultats des déterminations de la somme des phaseurs et de la différence d'amplitude et l'adaptation des premier et second seuils sur la base des données enregistrées.

12. Système de détection de défaut pour un système de transmission d'énergie (100) à courant alternatif, CA, comprenant une ligne de transmission d'énergie (101), le système de détection de défaut comprenant au moins un dispositif électrique intelligent, IED, pouvant être connecté à la ligne de transmission d'énergie, un IED local (111) de l'au moins un IED étant configuré pour :
- mesurer, à un emplacement local de la ligne de transmission d'énergie, des tensions de phase et des courants de phase, et déterminer leurs phaseurs en tant que phaseurs de tension locaux mesurés et en tant que phaseurs de courant locaux mesurés ;
- obtenir des propriétés de transmission pour la ligne de transmission d'énergie de la position locale vers une position distante à distance de la position locale et pour des dispositifs associés, les propriétés de transmission comprenant des paramètres de série, des paramètres de dérivation, et la distance de la position locale à la position distante ;
- estimer, pour la position distante, des phaseurs de tension distants estimés et des phaseurs de courant distants estimés sur la base des phaseurs de tension locaux mesurés, des phaseurs de courant locaux mesurés et des propriétés de transmission ;
- recevoir, à la position locale, par l'intermédiaire d'une liaison de communication, des données relatives à des courants de phase distants mesurés à la position distante et déterminer leurs phaseurs en tant que phaseurs de courant distants mesurés ;
- déterminer si un défaut s'est produit ou non sur la base d'au moins l'une d'une combinaison des phaseurs de courant distants estimés et des phaseurs de courant distants mesurés et d'une combinaison des phaseurs de tension distants estimés et des phaseurs de tension distants mesurés ; **caractérisé en ce que** l'au moins un IED est configuré pour :
- déterminer, lorsqu'il est déterminé qu'un défaut est survenu, si le défaut est un vrai défaut ou un faux défaut, comprenant :
∘ la détermination d'un phaseur de courant de séquence positive distant mesuré à partir des phaseurs de courant distants mesurés ;
∘ la détermination d'un phaseur de courant de séquence positive distant estimé à partir des phaseurs de courant distants estimés ;
∘ la comparaison d'un premier angle de phase et d'une première amplitude du phaseur de courant de séquence positive distant estimé avec un second angle de phase et une seconde amplitude du phaseur de courant de séquence positive distant mesuré ;
∘ la détermination sur la base de la comparaison s'il existe une asymétrie de canal significative sur le lien de communication ; et
∘ déterminer que le défaut est un faux défaut s'il y a une asymétrie de canal significative.

13. Système de détection de défaut selon la revendication 12, les paramètres de dérivation comprenant au moins l'un d'un facteur de dérivation directement entre la ligne de transmission d'énergie et la terre, et d'un facteur de dérivation d'au moins un réacteur de dérivation (116) compris dans les dispositifs associés et connecté à la ligne de transmission d'énergie (101).

14. Système de détection de défaut selon la revendication 13, un IED distant (112) dudit au moins un IED positionné à la position éloignée étant configuré pour mesurer les courants de phase distants.

15. Produit de programme informatique comprenant des instructions qui, lorsqu'elles sont téléchargées dans un dispositif électronique intelligent, IED, peuvent être connectées à une ligne de transmission d'énergie (101) d'un système de transmission d'énergie (100) à courant alternatif, CA, amènent le dispositif électronique intelligent à effectuer des opérations comprenant :
la mesure, à un emplacement local de la ligne de transmission d'énergie, de tensions de phase et de courants de phase, et la détermination de leurs phaseurs de phase en tant que phaseurs de tension locaux mesurés et phaseurs de courant locaux mesurés ;
- l'obtention de propriétés de transmission pour la ligne de transmission d'énergie de la position locale vers une position distante à distance de la position locale et pour des dispositifs associés, les propriétés de transmission comprenant des paramètres de série, des paramètres de dérivation, et la distance de la position locale à la position distante ;
- l'estimation, pour la position distante, de phaseurs de tension distants estimés et de phaseurs de courant distants estimés sur la base des phaseurs de tension locaux mesurés, des phaseurs de courant locaux mesurés et des propriétés de transmission ;
- la réception à la position locale, par l'intermédiaire d'une liaison de communication, de données relatives à des courants de phase distants, qui ont été mesurés à la position distante, et la détermination de leurs phaseurs en tant que phaseurs de courant distants mesurés,
- la détermination si un défaut s'est produit ou non sur la base d'au moins l'une d'une combinaison des phaseurs de courant distants estimés et des phaseurs de courant distants mesurés et d'une combinaison des phaseurs de tension distants estimés et des phaseurs de tension distants mesurés ; **caractérisé par** :
- lorsqu'il est déterminé qu'un défaut a eu lieu, la détermination si le défaut est un vrai défaut ou un faux défaut, comprenant :
∘ la détermination d'un phaseur de courant de séquence positive distant mesuré à partir des phaseurs de courant distants mesurés ;
∘ la détermination d'un phaseur de courant de séquence positive distant estimé à partir des phaseurs de courant distants estimés ;
∘ la comparaison d'un premier angle de phase et d'une première amplitude du phaseur de courant de séquence positive distant estimé avec un second angle de phase et une seconde amplitude du phaseur de courant de séquence positive distant mesuré ;
∘ la détermination sur la base de la comparaison s'il existe une asymétrie de canal significative sur le lien de communication ; et
∘ la détermination que le défaut est un faux défaut s'il existe une asymétrie de canal significative.
